# EUROPÄISCHE PATENTSCHRIFT

(11) **EP 1 116 338 B1**
(45) Veröffentlichungstag und Bekanntmachung des Hinweises auf die Patenterteilung: **24.11.2004**
(21) Anmeldenummer: 99955797.8
(22) Anmeldetag: 24.09.1999
(51) Int. Cl.: H04B 1/40, H03J 5/24, H04B 1/18

(54) **PROGRAMMIERBARES MOBILFUNK-ENDGERÄT**
PROGRAMMABLE MOBILE RADIOTELEPHONE TERMINAL
TERMINAL RADIOTELEPHONIQUE MOBILE PROGRAMMABLE

(30) Priorität: 25.09.1998 DE 19844142; 25.09.1998 DE 19844143; 28.04.1999 DE 19919368
(43) Veröffentlichungstag der Anmeldung: 18.07.2001
(73) Patentinhaber: SIEMENS AKTIENGESELLSCHAFT, 80333 München (DE)
(72) Erfinder: PILLEKAMP, Klaus-Dieter, D-40699 Erkrath (DE); TUO, Xihe, D-47057 Duisburg (DE); BIENEK, Bernd, D-46395 Bocholt (DE); GAPSKI, Dietmar, D-47058 Duisburg (DE)
(86) Internationale Anmeldenummer: PCT/DE1999/003079
(87) Internationale Veröffentlichungsnummer: WO 2000/019626

(56) Entgegenhaltungen:
- DE-A- 4 329 705
- US-A- 5 164 688
- US-A- 5 619 061
- US-A- 5 696 662

## Beschreibung

Die Erfindung betrifft ein Mobilfunk-Endgerät mit einer Sendestufe, einer Empfangsstufe sowie einer Antennenumschalt- und -anpaßstufe, die jeweils eine Anordnung passiver Bauelemente aufweisen und in mindestens je einem Funktionsparameter programmierbar sind. Die Erfindung betrifft weiterhin einen programmierbaren Mobilfunk-HF-Block.

Mobilfunk-Endgeräte sind, was ihren nachrichtentechnischen Teil betrifft, im Mikrowellenbereich arbeitende mobile Funkempfangs- und - sendestationen. Die Nutzung von nahe dem oder im Gigahertz-Bereich liegenden Betriebsfrequenzen (beispielsweise beim GSM-System ca. 900 Mhz, beim DCS-System annähernd 1800 Mhz) hat zur Folge, daß für ihren Betrieb komplizierte Ausbreitungsbedingungen bestimmend sind, deren Folgen - insbesondere ein zeitlich sehr stark schwankender Schwund in Folge von Überlagerungen und Mehrwegeempfang - besonderer Aufmerksamkeit beim Geräteentwurf bedürfen. Zwar liegen die wichtigsten Maßnahmen zur Beherrschung der auf der Ausbreitungsstrecke (der sogenannten "Luftschnittstelle") bestehenden Probleme auf dem Gebiet der digitalen Signalverarbeitung, auch die Ausbildung der HF-Komponenten ist jedoch von großer Bedeutung für die Gewährleistung der erforderlichen Übertragungsqualität.

In diesem Zusammenhang ist es wünschenswert, wesentliche Funktionsparameter der HF-Teile in einem relativ großen Bereich, sehr schnell und auf einfache, an den Gesamtaufbau des Mobilfunk-Endgerätes angepaßte Weise einstellbar zu gestalten. Als ideal wird eine umfassende Programmierbarkeit der HF-Teile anzusehen sein, von einer solchen ist die praktische Ausführung der HF-Teile von Mobilfunk-Endgeräten aber weit entfernt. Sie beschränkt sich derzeit auf die Möglichkeit des Ein- und Ausschaltens eines Funktionsblocks, der Steuerung der Ausgangsleistung oder Verstärkung eines Blockes durch Vorspannungs- oder Stromänderungen o.ä.

Bei Mobilfunkgeräten gemäß dem Stand der Technik ist praktisch keine Veränderbarkeit bzw. Programmierbarkeit der elektronischen Bauteile wie beispielsweise der HF-Blöcke oder Filterschaltungen möglich. Um indessen sogenannte software-definierte Mobiltelefone oder ähnliches zu schaffen, müssen die elektronischen bzw. elektrischen Bauteile in dem Mobiltelefon möglichst frei programmierbar sein, wobei diese Programmierbarkeit auch nach der Endfertigung des Mobilfunkgeräts noch vorhanden sein soll. Da darüber hinaus bekanntlich in Mobilfunkanwendungen Bauteile mit geringen Abmessungen, hohe Linearität, und mit niedrigem Energieverbrauch gewünscht sind, weisen Produkte, die auf einer Yig-, Pin-Dioden- oder Varaktor-Technologie basieren, dementsprechende Nachteile auf.

Insbesondere die in Mobilfunkgeräten verwendeten Filter und Duplexer sollten also geringe Abmessungen aufweisen, einen geringen Energieverbrauch aufweisen, hohe Linearität, und darüber hinaus möglichst frei programmierbar sein.

Aus der US 5,619,061 sind mikromechanische Mikrowellenschalter bekannt zum ohmschen als auch kapazitiven Anschluss von Hochfrequenzsignalen und zur Integration in Wechselschaltern für eine Anwendung in Mikrowellenschaltungsanordnungen.

Aus der US 5,696,662 ist ein elektrostatisch gesteuerter mikromechanischer Kondensator bekannt, der einen sehr breiten Einstellbereich aufweist.

Aus der DE 30 10 707 A1 ist ein Verfahren und eine Anordnung zur rechnergesteuerten Abstimmung von Vorselektionskreisen bei Hochfrequenzempfängern bekannt.

Der Erfindung liegt die Aufgabe zugrunde, ein hinsichtlich des Aspektes der Programmierbarkeit der wesentlichen Funktionsparamter der HF-Teile verbessertes Mobilfunk-Endgerät zu ermöglichen.

Diese Aufgabe wird durch die Merkmale der unabhängigen Ansprüche gelöst.

Die Erfindung schließt den wesentlichen Gedanken ein, in der HF-Sendestufe, der HF-Empfangsstufe und der Antennenumschalt- und - anpaßstufe - als den wesentlichen HF-Komponenten - jeweils eine Mikroschalter- bzw. Mikrorelais-Anordnung vorzusehen, mit der die dort enthaltenen und bestimmte Funktionsparameter bestimmenden passiven Bauelemente auf vorbestimmte Weise aus Sub-Elementen konfiguriert werden können.

Derartige Mikroschalter bzw. Mikrorelais sind in vielgestaltigen Ausführungsformen aus der US 5 619 061 bekannt, in der auch ihre Anwendung zur Abstimmung einer Filterschaltung oder zur Antennen-Selektivitätsabstimmung erwähnt wird.

Vorgesehen ist eine Ausführung, bei der mindestens eine der genannten HF-Komponenten weiterhin Mikromotoren zur mechanischen Verstellung passiver Bauelemente aufweist, wobei die Mikromotoren ebenfalls in Steuerverbindung mit einer Steuereinheit stehen, über die die Mikroschalter bzw. -relais angesteuert werden. Die kennwertbestimmende Bauelementkonfiguration der jeweiligen HF-Komponente läßt sich durch den kombinierten Einsatz einer Mikroschalteranordnung und von Verstellmotoren hinsichtlich Bauvolumen, Energieverbrauch, Linearität und Ansteueraufwand weiter optimieren.

Zur Verringerung der Baugröße sowie des Herstellungsaufwandes ist eine Ausführung von Vorteil, in der mindestens ein Teil der Mikroschalter bzw. -relais sowie - falls solche zusätzlich vorgesehen sind - Mikromotoren mit den durch sie beeinflußten passiven Bauelementen auf einem gemeinsamen Substrat integriert ist. Hierfür eignet sich besonders ein keramisches Substrat mit einer hohen Dielektrizitätskonstanten.

Die in Sub-Elemente untergliederten passiven Bauelemente bilden zusammen mit den die Sub-Elemente verbindenden Mikroschaltern eine Topologie, die zweckmäßigerweise in einem Topologiespeicher der Steuereinheit abgespeichert wird. Weiterhin umfaßt die Steuereinrichtung in einer bevorzugten Ausführung einen Algorithmenspeicher zur Speicherung eines Berechnungsalgorithmus für den oder die zu programmierenden Funktionsparameter und eine Berechnungsstufe zur Berechnung der einen vorbestimmten Wert des jeweiligen Funktionsparameters liefernden aktiven Topologie. Durch entsprechende Vergleichermittel kann aus einem Vergleich der errechneten aktiven Topologie mit der insgesamt vorhandenen Topologie unmittelbar eine Schaltmatrix gewonnen werden, die sodann durch Ausgabe entsprechender Schaltsteuersignale an die einzelnen Mikroschalter realisiert wird.

In einer abweichenden Ausführung umfaßt die Steuereinheit einen Mehrbereichs-Konfigurationenspeicher (in Art eines sogenannten "Lookup-Table") zur Speicherung einer Mehrzahl von Mikroschalter-Schaltmatrizen der in dem HF-Teil realisierten Topologie, jeweils in Zuordnung zu einem Wert eines Funktionsparameters oder einem Werte-Vektor mehrerer Funktionsparameter, sowie eine Zeigerstufe zur Adressierung des Konfigurationenspeichers, die auf die Eingabe (Programmierung) eines solchen Wertes oder Werte-Vektors anspricht.

Für die vorhandenen Mikromotoren sind - bei etwas erhöhtem Speicher- bzw. Speicher- und Verarbeitungsaufwand - beide genannten Realisierungen möglich. Die durch Mikromotoren beeinflußten Abschnitte der Bauelementanordnung sind dabei vorteilhaft in (fiktive) Sub-Elemente entsprechend den ansteuerbaren Motorstellungen untergliedert, und ihre Struktur läßt sich somit analog abspeichern und handhaben wie eine Struktur aus durch Mikroschalter voneinander getrennten realen Sub-Elementen.

Als in diskreten Schritten (durch Betätigung der Mikroschalter und wahlweise Mikromotoren) einzustellender Funktionsparameter ist insbesondere die Frequenzcharakteristik der jeweiligen HF-Komponente zu sehen. Als zu schaltende passive Bauelemente sind Kondensatoren und/oder Induktivitäten und/oder Mikrostripleitungsabschnitte oder auch Resonatoren vorhanden. Diese zeigen sämtlich grundsätzlich ein lineares Verhalten, so daß gegenüber einer Beeinflussung der Frequenzcharakteristik mittels aktiver Bauelemente, wie Varactoren oder Transistoren, keinerlei Nichtlinearitäten oder Verzerrungen zu befürchten sind. Zudem haben die elektrostatisch gesteuerten Mikroschalter keine Leistungsaufnahme.

Für den konkreten Einstellvorgang ist ein bestimmtes Vorgehen einzuhalten, um die Mikroschalter und gegebenenfalls Mikromotoren oder auch andere Anordnungsteile vor Überströmen und Spannungsspitzen zu schützen. Hierzu ist die einzustellende HF-Komponente und bevorzugt der gesamte HF-Teil in einen inaktiven Zustand zu schalten. Anschließend kann auf eine der oben skizzierten Weisen die Bestimmung - der aktuell benötigten Mikroschalter-Konfiguration bzw. der zu realisierenden Kombination aus Mikroschalter-Konfiguration und Mikromotoren-Ansteuerung ermittelt werden. Schließlich wird die vorbestimmte Schalterkonfiguration bzw. Schalterstellungs-/Motoransteuerungs-Kombination durch die Steuereinheit realisiert, und zuletzt werden die HF-Komponenten bzw. das gesamte Mobilfunk-Endgerät wieder in den aktiven Zustand überführt. Dem hier beschriebenen Vorgehen entspricht natürlich eine Funktionalität (Programmierung) der Steuereinheit, die den Ablauf selbsttätig realisiert.

Gemäß einem weiteren Aspekt ist ein programmierbarer HF-Block für Mobilfunkanwendungen vorgesehen. Dieser programmierbare HF-Block weist mindestens ein aktives Bauteil und wenigstens ein mechanisch abstimmbares Anpassungsnetzwerk auf, das individuell einstellbare passive Bauteile aufweist und mit dem aktiven Bauteil verbunden ist. Weiterhin ist eine programmierbare Steuereinheit vorgesehen, die das mechanisch abstimmbare Anpassungsnetzwerk so einstellt, daß der HF-Block insgesamt vorbestimmte Eigenschaften hinsichtlich seines Signalantwortverhaltens aufweist.

Jeweils einem einstellbaren passiven Bauteil ist dabei ein elektrischer Mikromotor zugeordnet, so daß die programmierbare Steuereinheit durch Ansteuerung der Mikromotoren die Einstellung des mechanisch abstimmbaren Anpassungsnetzwerks vornehmen kann.

Die Mikromotoren werden dabei nur während der Zeitdauer der Einstellung des mechanisch abstimmbaren Anpassungsnetzwerks aktiviert, wohingegen außerhalb der genannten Zeitdauer die elektrische Versorgung der Mikromotoren beispielsweise durch die programmierbare Steuereinheit abgeschaltet wird, um den Energieverbrauch zu senken, was insbesondere bei Mobilfunkanwendungen wichtig ist.

Vorteile und Zweckmäßigkeiten der Erfindung werden im übrigen aus den Unteransprüchen sowie der nachfolgenden Beschreibung bevorzugter Ausführungsbeispiele anhand der Figuren deutlich. Von diesen zeigen:
- Fig. 1: ein stark vereinfachtes Funktions-Blockschaltbild eines Mobilfunk-Endgerätes zur Erläuterung der Erfindung anhand einer Ausführungsform,
- Fig. 2a: ein Prinzipschaltbild einer Resonatorschaltung, wie sie in einem der Filterbausteine bzw. im Duplexer des Mobilfunk-Endgerätes nach Fig. 1 eingesetzt wird,
- die Figuren 2b bis 2e: verschiedene Realisierungen der Schaltung nach Fig. 2a gemäß Ausführungsformen der Erfindung unter Einsatz von Mikroschaltern bzw. Mikrorelais,
- die Figuren 2f und 2g: modifizierte Ausführungsformen einer abstimmbaren Resonatorschaltung, bei denen neben Mikrorelais bzw. Mikroschaltern auch Mikromotoren vorgesehen sind,
- Fig. 3: ein Funktions-Blockschaltbild einer Steueranordnung zur Abstimmung einer Filterstufe des Mobilfunk-Endgerätes nach Fig. 1,
- Fig. 4: eine Skizze der Steuerung gemäß einer weiteren Ausführungsform,
- Fig. 5a - 5c: schematische Schaltbilder von Ausführungsbeispielen der vorliegenden Erfindung, in denen abstimmbare Anpassungsnetzwerke mit einem Verstärker (Fig. 5a), einem Mischer (Fig. 5b) bzw. einem Oszillator (Fig. 5c) verbunden werden,
- Fig. 6: eine detaillierte Ansicht eines abstimmbaren Anpassungsnetzwerkes gemäß der vorliegenden Erfindung,
- Fig. 7a: einen schematischen Schaltplan einer erfindungsgemäßen programmierbaren Filterschaltung,
- Fig. 7b: einen Duplexer, der zwei programmierbare Filterschaltungen aufweist, deren Bauteile so eingestellt sind, daß die Filterschaltungen insgesamt verschiedene Frequenzkennlinien aufweisen,
- Fig. 8: ein Ausführungsbeispiel für die Realisierung einer Filterschaltung bestehend aus Kondensatoren und Induktivitäten/Resonatoren, deren Kennwerte mechanisch eingestellt werden können,
- Fig. 9: einen Ausschnitt von Fig. 8, der in Fig. 2 mit a) bezeichnet ist, wobei in Fig. 9 darüber hinaus die Ansteuerung zur Einstellung der Kennwerte eines Kondensators dargestellt ist,
- Fig. 10: einen Ausschnitt von Fig. 8, welcher die Draufsicht eines Leitungsresonators zeigt, der durch einen Kurzschlußschieber in seinen elektrischen Eigenschaften geändert wird, der in Fig. 8 mit b) bezeichnet ist, und
- Fig. 11: ein weiteres Ausführungsbeispiel zur Schaffung eines Kondensators, dessen Kapazitätswert mechanisch durch einen Mikromotor verstellt werden kann.

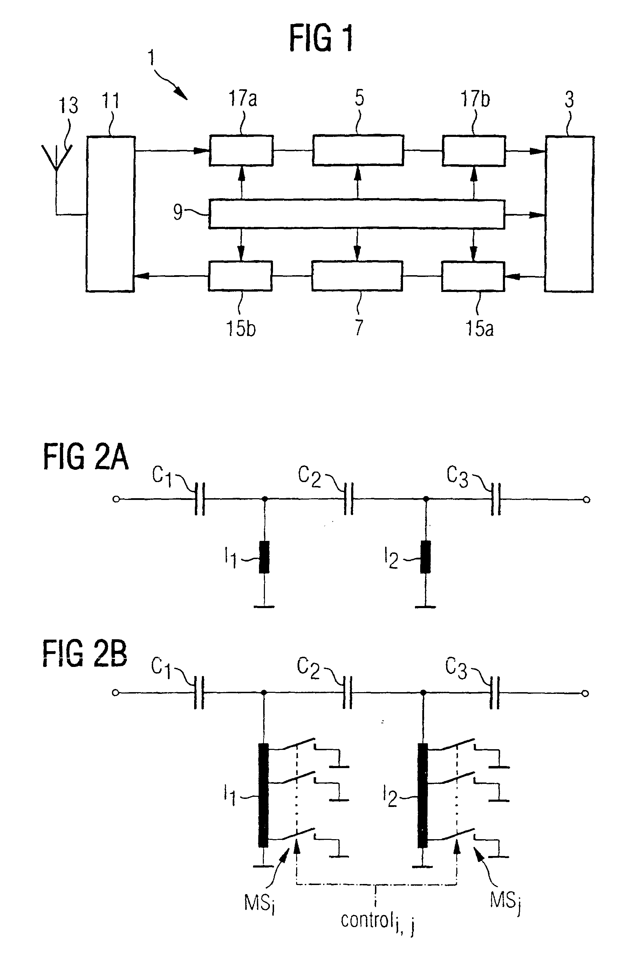

Fig. 1 zeigt in einer stark vereinfachenden Prinzipskizze ein Mobilfunk-Endgerät 1, das einen insbesondere die NF-Komponenten und Sprachsignalverarbeitungsmittel umfassenden Basisband-Block 3, eine Empfangsstufe 5, eine Sendestufe 7, ein Steuerteil 9, einen Duplexer 11 und eine Antenne 13 aufweist. Im senderseitigen Signalweg sind zwischen dem Basisband-Block 3 und der Sendestufe 7 sowie zwischen letzterer und dem Duplexer 11 jeweils eine abstimmbare Sendesignal-Filterstufe 15a, 15b und im empfängerseitigen Signalweg zwischen dem Duplexer 11 und der Empfangsstufe 5 sowie zwischen dieser und dem Basisband-Block 3 jeweils eine abstimmbare Empfangssignal-Filterstufe 17a, 17b vorgesehen. Zusammenfassend kann man die Empfangsstufe 5 und die zugehörigen Empfangssignal-Filterstufen 17a, 17b auch als Empfangsstufe im weiteren Sinne und die Sendestufe 7 zusammen mit den Sendesignal-Filterstufen 15a, 15b als Sendestufe im weiteren Sinne bezeichnen. Bei einer etwas anderen Betrachtungsweise könnte man die abstimmbaren Filterstufen 15b und 17a auch dem Duplexer 11 zurechnen und diese kombinierte Funktionseinheit als Antennenumschalt- und -anpaßstufe bezeichnen. Insofern der Basisband-Block (an sich bekannte Mittel) zur Quellenkodierung, Kanalkodierung und Verschachtelung sowie Burstbildung auf der Senderseite sowie entsprechende Entschachtelungs-, Kanaldekodierungs- und Quellendekodierungsmittel auf der Empfängerseite aufweist, besteht eine enge funktionelle Verknüpfung mit dem Steuerteil, das natürlich Mittel zur Steuerung der mit dem jeweiligen Mobilfunk-Systemstandard konformen Funktionsabläufe des Mobilfunk-Endgerätes aufweist. Im Zusammenhang mit der Erläuterung der Erfindung besonders wesentlich sind die Steuerfunktionen des Steuerteils 9 bezüglich der Empfangsstufe 5, der Sendestufe 7 und der Filterstufen 15a, 15b sowie 17a, 17b. Diese werden daher weiter unten noch genauer erläutert.

Fig. 2a zeigt eine Resonatoranordnung aus drei in Reihe geschalteten Kondensatoren C1, C2 und C3 und zwei Induktivitäten 11, 12, die den Leitungsabschnitt zwischen den Kondensatoren C1, C2 bzw. den Abschnitt zwischen den Kondensatoren C2, C3 mit Masse verbinden. Eine solche Resonatoranordnung ist in den Filterstufen 15a, 15b, 17a und 17b bzw. der Empfangsstufe und der Sendestufe im weiteren Sinne bzw. der Antennenumschalt- und -anpaßstufe implementiert.

In Fig. 2b ist skizzenhaft dargestellt, daß die Induktivitäten 11, 12 der Anordnung nach Fig. 2a in vorbestimmter Anordnung jeweils eine Mehrzahl von Anzapfungen aufweisen, die über je einen Mikroschalter mit Masse verbindbar sind. Die der Induktivität 11 zugeordneten Mikroschalter sind in der Figur mit MSᵢ bezeichnet und werden über Steuersignale "controlᵢ" einzeln angesteuert, während die der Induktivität l₂ zugeordneten Mikroschalter mit MSⱼ bezeichnet sind und über Steuersignale "controlⱼ" angesteuert werden. Die Mikroschalter MS_{i,j} teilen - je nach Schalterstellung - mehr oder weniger große Teile der Induktivitäten 11, 12 ab, so daß durch ihre Ansteuerung eine Einstellung der Frequenzcharakteristik der Resonatoranordnung erfolgen kann.

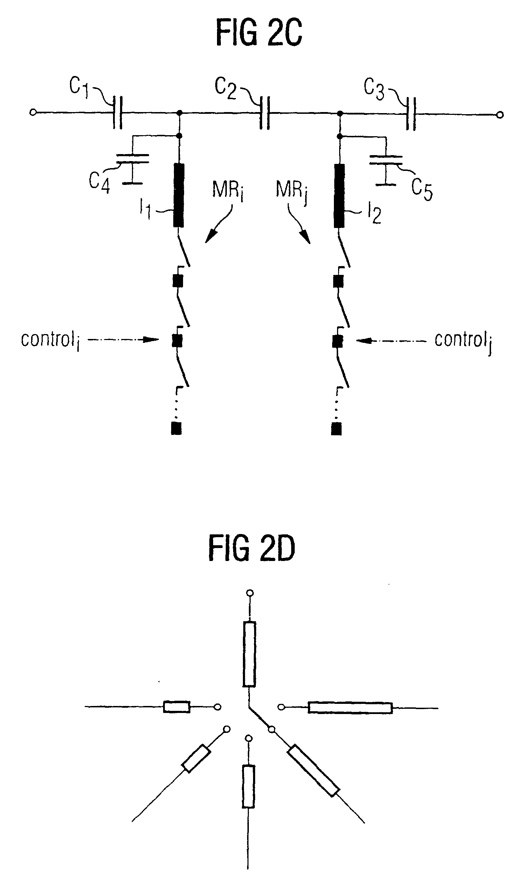

Eine etwas modifizierte Ausführung dieses Prinzips zeigt Fig. 2c, wo die Induktivitäten 11, 12 jeweils durch eine Gruppe von Mikrorelais MRᵢ bzw. MRⱼ angesteuert durch Ansteuersignale "controlᵢ" bzw. "controlⱼ", in Sub-Induktivitäten unterteilt sind. Diese Schaltung, in der noch zwei Massekondensatoren C4, C5 vorgesehen sind, stellt eine Leerlaufschaltung dar, während die Ausführung nach Fig. 2b als Kurzschlußschaltung anzusprechen ist.

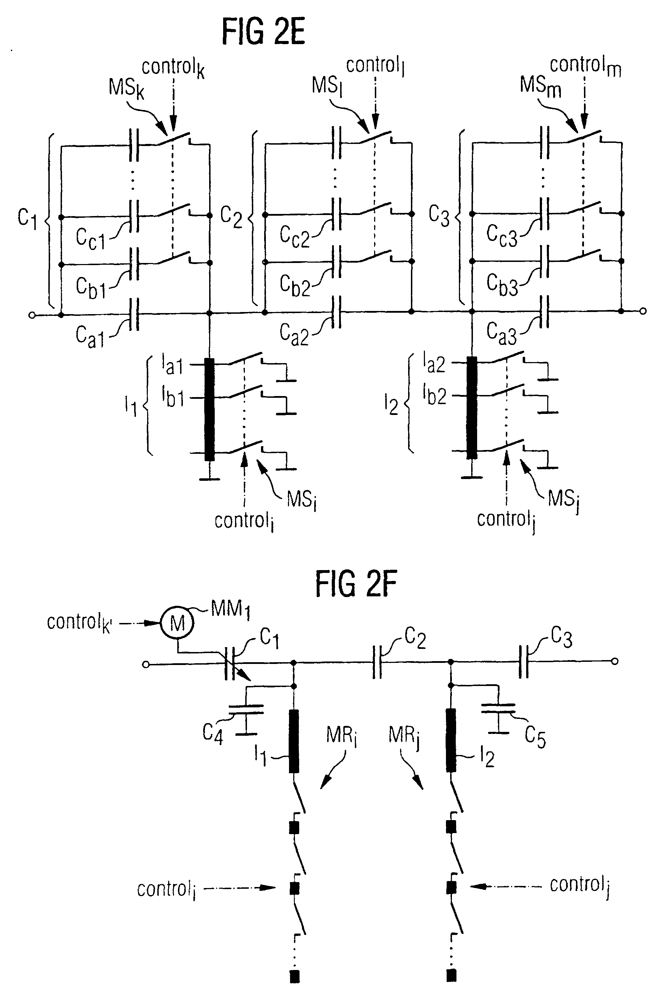

In Fig. 2d ist eine sternförmige Schalterkonfiguration gezeigt, die an die Stelle der seriellen Schalteranordnung nach Fig. 2b oder 2c treten kann. Fig. 2e zeigt eine gegenüber Fig. 2b insofern modifizierte Anordnung, als hier neben den Induktivitäten 11, 12 auch die Kondensatoren C₁, C₂ und C₃ durch Mikroschalter in Sub-Bauelemente untergliedert und durch Schalterbetätigungen abstimmbar sind. In Entsprechung zur Darstellung der Fig. 2b sind die den Kondensatoren C1 bis C3 zugeordneten Schalter mit MSₖ, MSₗ bzw. MSₘ und die zugehörigen Steuersignale entsprechend mit "controlₖ", "controlₗ" bzw. "controlₘ" bezeichnet. Die Sub-Induktivitäten von 11 sind hier mit lₐ₁, l_{b1}, ... und diejenigen von 12 mit lₐ₂, l_{b2}, ... bezeichnet, und analog sind die Sub-Kapazitäten des Kondensators C1 mit Cₐ₁, C_{b1}, C_{c1}, ... , diejenigen des Kondensators C2 mit Cₐ₂, C_{b2}, C_{c2}, ... und diejenigen des Kondensators C3 mit Cₐ₃, C_{b3}, C_{c3}, ... bezeichnet. An dieser Figur ist besonders deutlich zu erkennen, daß durch die Untergliederung von passiven Bauelementen eines Filter- bzw. Anpaßbereiches in Sub-Bauelemente mittels Mikroschaltern bzw. Mikrorelais eine Topologie entwickelt wird, die eine Vielzahl von durch bestimmte Schalteransteuerungen realisierbaren Konfigurationen in sich birgt.

Fig. 2f zeigt eine gegenüber Fig. 2c dahingehend abgewandelte Ausführung, daß der Kondensator C1 durch einen Mikromotor MM₁, angesteuert durch ein Steuersignal "control_{k'}", in seiner Kapazität veränderbar ist. Es versteht sich von selbst, daß auch die Kondensatoren C2 und C3 durch einen ihnen zugeordneten Mikromotor mit entsprechender Ansteuerung einstellbar ausgeführt sein können.

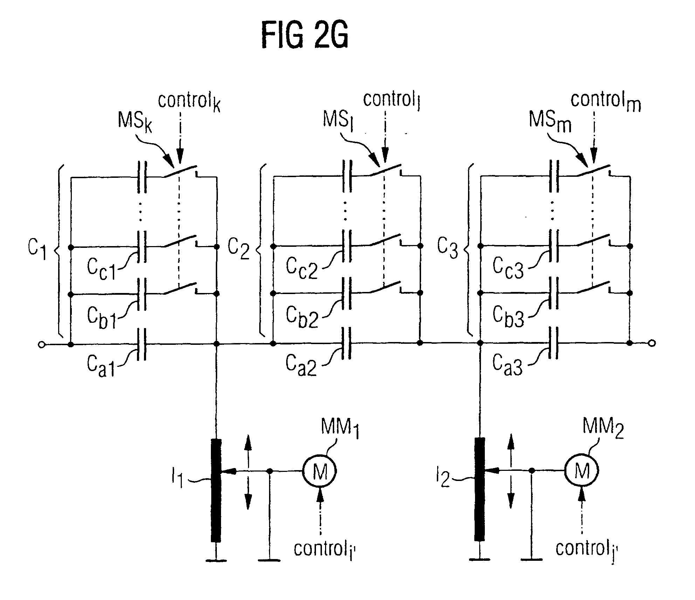

In der Anordnung nach Fig. 2g ist die in Fig. 2e gezeigte Anordnung mit in Sub-Kapazitäten unterteilten Kondensatoren C1, C2 und C3 hinsichtlich der Induktivitäten dahingehend modifiziert, daß diese jeweils einen über einen Mikromotor MM₁ bzw. MM₂ verschiebbaren Masseabgriff aufweisen. In Annäherung an Fig. 2e wurden die entsprechenden Steuersignale hier mit "control_{i'}" bzw. "control_{j'}" bezeichnet.

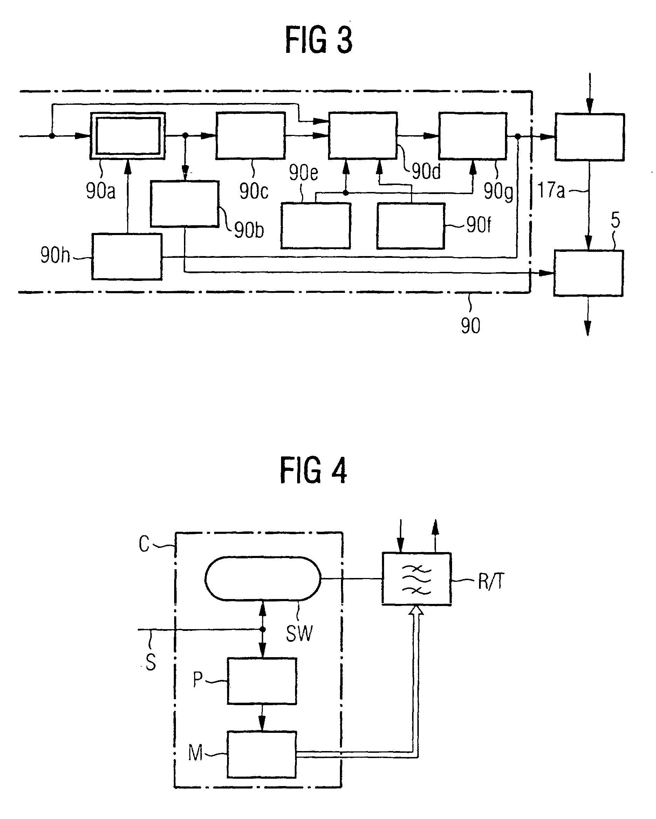

Fig. 3 zeigt in Art eines Funktions-Blockschaltbildes skizzenartig den Aufbau einer Abstimmsteuerung 90 (deren Bezugsziffer an das Steuerteil 9 aus Fig. 1 angelehnt wurde) zur Abstimmung einer Empfangssignal-Filterstufe 17a gemäß Fig. 1. Die Abstimmsteuerung 90 umfaßt eine Abstimmablaufsteuerung 90a, die ein von extern zugeführtes Signal empfängt, welches eine angeforderte Frequenzcharakteristik der Empfangssignal-Filterstufe 17a repräsentiert.

Die Abstimmablaufsteuerung 90a ist mit der Empfangsstufe 5 über einen Ein-/Ausschalter 90b verbunden, über den sie bei Empfang des erwähnten Signals, aufgrund dessen eine Abstimmung der Empfangssignal-Filterstufe 17a vorzunehmen ist, zunächst die Empfangsstufe 5 abschaltet. Das zur Betätigung des Ein-/Ausschalters erzeugte Signal wird über einen Inverter 90c weiterhin einer Schalterkonfigurations-Berechnungsstufe 90d zugeführt und aktiviert diese, woraufhin diese das oben erwähnte, eine Frequenzcharakteristik spezifierende Signal, das auch an ihrem Eingang anliegt, empfängt und zwischenspeichert. Unter Zugriff auf einen Topologiespeicher 90e, in dem die spezifische, aus den passiven Bauelementen bzw. Sub-Elementen und zugeordneten Mikroschaltern bzw. Mikrorelais und ggfs. Mikromotoren gebildete Filtertopologie der Empfangs-Filterstufe 17a abgelegt ist, und einen Algorithmenspeicher 90f, in dem ein entsprechender Algorithmus zur Bestimmung der konkreten Schalterkonfiguration aufgrund einer vorbestimmten Frequenzcharakteristik gespeichert ist, berechnet die Schalterkonfigurations-Berechnungsstufe 90d die aufgrund der angeforderten Frequenzcharakteristik zu realisierende Ansteuerkonfiguration der Mikroschalter bzw. -relais und gegebenenfalls Mikromotoren und gibt diese an einen Ansteuersignalgenerator 90g aus. Dieser erzeugt - ebenfalls unter Zugriff auf den Topologiespeicher 90e - hieraus die Ansteuersignale für jeden einzelnen Schalter der Gesamtkonfiguration und führt sie sequentiell der Empfangssignal-Filterstufe 17a zu. Die Ausgabe des letzten Ansteuersignals wird durch einen Programmende-Detektor 90h erfaßt, der ein entsprechendes Signal an die Abstimmablaufsteuerung 90a ausgibt, die daraufhin den Ein-/Ausschalter 90b zum Wiedereinschalten der Empfangsstufe 5 aktiviert und die Schalterkonfigurations-Berechnungsstufe 90d deaktiviert. (Die hier beschriebenen Funktionen werden in der Praxis größtenteils softwaremäßig realisiert sein, so daß die hier gegebene Beschreibung anhand von Funktionsblöcken nur als Illustration des Prinzips zu verstehen ist.)

In Fig. 4 ist skizzenhaft (in einer etwas anderen Darstellungsweise) eine alternative Ausführung der Steuerung dargestellt. Eine Steuereinheit C umfaßt einen Konfigurationenspeicher M, in dem in Zuordnung zu jeweils einer Frequenzcharakteristik aus einer vorbestimmten Menge von Frequenzcharakteristiken eine vorbestimmte Menge von Schalterstellungskonfigurationen einer Bauelement-/Mikroschalter-Anordnung eines HF-Teils R/T eines Mobilfunk-Endgerätes gespeichert ist. Eine Eingangssignalleitung S der Steuerung C ist einerseits mit einem Ein-/Ausschalter Sw und andererseits mit einer Zeigerstufe P verbunden, die ihrerseits den Konfigurationenspeicher M adressieren kann.

Bei Eingang eines Befehlssignals zur Einstellung einer vorbestimmten Frequenzcharakteristik auf der Signalleitung S wird über den Ein-/Ausschalter Sw das HF-Teil R/T in einen Default-Modus versetzt und andererseits der Zeiger P zur Adressierung des Konfigurationenspeichers M entsprechend der angeforderten Frequenzcharakteristik aktiviert. Der Speicherinhalt wird an das HF-Teil ausgelesen und dort eine entsprechende Einstellung der Mikroschalteranordnung vorgenommen. Nach Beendigung dessen wird - entsprechend der Ausführung nach Fig. 3 - das HF-Teil wieder in Betrieb genommen.

Die Ausführung der Erfindung ist nicht auf die hier beschriebenen Ausführungsbeispiele beschränkt, sondern auch in einer Vielzahl von Abwandlungen möglich. Insbesondere können auch Widerstände als passive Bauelemente durch Mikroschalter bzw. - relais in Sub-Elemente unterteilt und auf diese Weise insbesondere Impedanzanpassungen bewirkt werden. Hierbei ist der Einsatz von Mikrostrip-Leitungen für viele Anwendungen besonders zweckmäßig. Eine Kombination von Mikroschaltern mit Mikromotoren kann auch bei passiven Bauelementen desselben Typs in derselben Anordnung zweckmäßig sein, wenn sie zu einer Verringerung des Herstellungsaufwandes und Bauvolumens bzw. des Ansteuerungsaufwandes führt.

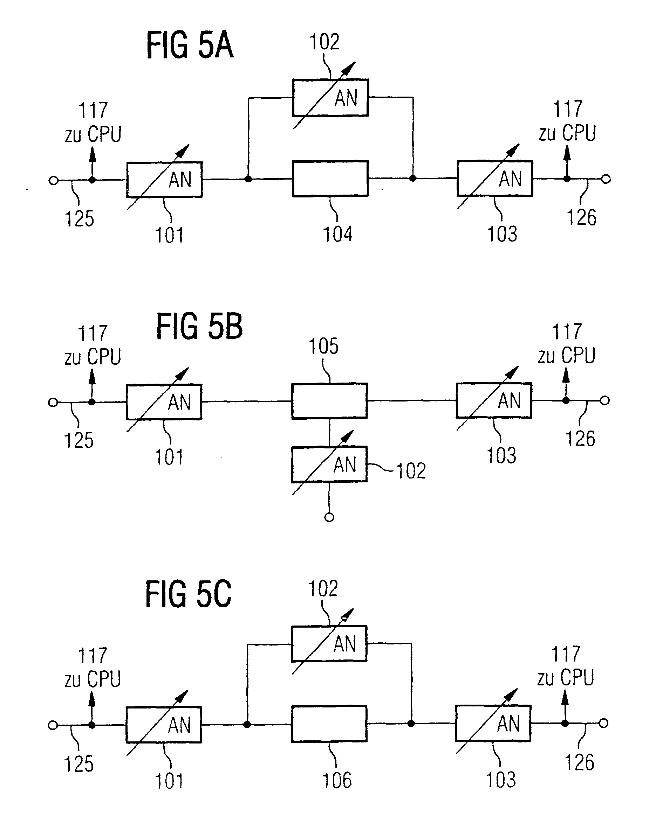

In Fig. 5a ist der Fall gezeigt, daß individuell einstellbare Abstimmnetzwerke 1, 2, 3 parallel (siehe Abstimmnetzwerk 2) bzw. seriell (siehe Abstimmnetzwerke 1, 3) mit einem aktiven Bauteil verschaltet sind, das in diesem Fall ein Verstärker 4 ist.

Fig. 5b zeigt den Fall, daß drei individuell einstellbare Abstimmnetzwerke 1, 2, 3 mit einem aktiven Bauteil 5 verschaltet sind, das in diesem Fall ein Mischer ist.

Fig. 5c zeigt den Fall, daß drei individuell einstellbare Abstimmnetzwerke 1, 2, 3 mit einem aktiven Bauteil 6 verschaltet sind, das ein Oszillator 6 ist.

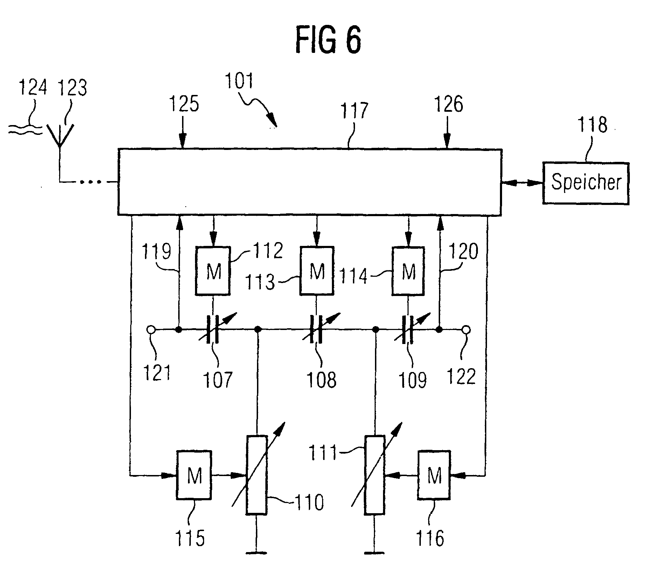

In Fig. 6 ist detailliert der Aufbau eines Abstimmnetzwerkes 101, 102, 103 gemäß der vorliegenden Erfindung dargestellt. Das als Ausführungsbeispiel dargestellte Abstimmnetzwerk 101 weist drei Kondensatoren 107, 108, 109 auf, die seriell zwischen einem Eingang 121 und einem Ausgang 122 geschaltet sind und deren Kapazitätswert individuell mechanisch einstellbar ist. Weiterhin sind zwei Induktivitäten oder Resonatoren 110, 111 zwischen dem Verbindungspunkt zwischen dem Kondensator 107 und dem Kondensator 108 bzw. zwischen dem Kondensator 108 und dem Kondensator 109 und Erde geschaltet.

Die Kapazitätswerte der Kondensatoren 107, 108, 109 können beispielsweise durch Verschieben oder Drehen einer Metallplatte der Kondensatoren durch einen Mikromotor eingestellt werden. Die Kennwerte der Resonatoren oder Induktivitäten 110, 111 können durch Verschieben des Erdungspunkts mechanisch eingestellt werden.

Jedem der einstellbaren passiven Bauteile 107, 108, 109, 110, 111 ist ein elektrischer Mikromotor 112, 113, 114, 115, 116 zugeordnet, der die mechanische Verstellung der Kennwerte der entsprechenden Bauteile vornimmt. Die Mikromotoren 112, 113, 114, 115, 116 werden dabei von einer Steuereinheit 217 angesteuert. Die Steuereinheit 117 erfaßt das Signalantwortverhalten einerseits eines jeden Anpassungsnetzwerks 101, 102, 103, in dem ihnen die Signale, die an dem Eingang 121 bzw. dem Ausgang 122 eines jeden Anpassungsnetzwerks 101, 102, 103 anliegen, an Eingänge 119, 120 zugeführt werden, und andererseits das Signalantwortverhalten des HF-Blocks insgesamt, indem der Steuereinheit 117 diejenigen Signale zugeführt werden, die an dem Eingang 125 bzw. dem Ausgang 126 des HF-Blocks insgesamt anliegen. Die Steuereinheit 117 kann somit die einzelnen passiven Bauteile 107, 108, 109, 110, 111 eines jeden mechanisch abstimmbaren Anpassungsnetzwerks mittels der elektrischen Mikromotoren 112, 113, 114, 115 und 116 abhängig von dem Signalantwortverhalten eines jeden Anpassungsnetzwerks und/oder des HF-Blocks insgesamt einstellen.

Wie in Fig. 6 ebenfalls ersichtlich ist, kann die entsprechende Programmierung der Steuereinheit 117 auch online über eine Luftschnittstelle 124 und eine Antenne 123 erfolgen. Das heißt, beispielsweise ein Mobiltelefon, in dem ein HF-Block gemäß der vorliegenden Erfindung eingebaut ist, kann über die Luftschnittstelle 124 und die Antenne 123 online von einer Basisstation her programmiert werden.

Wie in Fig. 6 ebenfalls ersichtlich ist, ist mit der Steuereinheit 117 ein Speicher 118 verbunden. Dieser Speicher kann beispielsweise ein PROM sein. In diesem Speicher 118 können Einstellwerte für die einzelnen passiven Bauteile 107, 108, 109, 110, 111, d. h. die entsprechenden Ansteuerwerte für die jeweils zugeordneten Mikromotoren 112, 113, 114, 115 bzw. 116 dauerhaft abgelegt werden. Darüber hinaus kann in dem Speicher 118 eine Tabelle vorgesehen sein, in der angegeben ist, welche einzelnen Einstellwerte für die passiven Bauteile erforderlich sind, um vorbestimmte Signalantwortverhalten der einzelnen Anpassungsnetzwerke 101, 102, 103 bzw. des HF-Blocks insgesamt zu erzielen.

Alternativ kann die programmierbare Steuereinheit 117 die zur Erzielung eines bestimmten Signalantwortverhaltens des HF-Blocks erforderlichen Einstellwerte für das/die mechanisch abstimmbare(n) Anpassungsnetzwerk(e) selbst berechnen.

Gemäß der vorliegenden Erfindung wird also eine vollständige Programmierbarkeit eines HF-Blocks für Mobilfunkanwendungen gewährleistet. Daraus ergeben sich mehrere Vorteile. Zuerst einmal wird aufgrund der Verwendung von rein passiven Komponenten in den Anpassungsnetzwerken, d. h. von mechanisch abstimmbaren Kondensatoren, Spulen und Resonatoren, nur während der eigentlichen Einstellzeitdauer elektrische Energie verbraucht. Sobald das Anpassungsnetzwerk eingestellt ist, kann die Steuereinheit 117 beispielsweise die elektrische Versorgung für die elektrischen Mikromotoren 112, 113, 114, 115, 116 abschalten, um sicherzustellen, daß keinerlei elektrische Energie außerhalb der genannten Zeitdauer verbraucht wird. Dies ist von besonders großer Bedeutung bei batteriebetriebenen Mobilfunktelefonen.

Dadurch, daß nur passive Komponenten verwendet werden, gibt es weniger Probleme hinsichtlich Nichtlinearität und Verzerrung im Gegensatz zu dem Fall, daß andere aktive Komponenten wie beispielsweise Varaktoren oder Transistoren verwendet werden. Darüber hinaus kann die Größe der Schaltungsblöcke durch Verwendung eines kompakten Lay-outs und Materialien mit einer hohen Dielektrizitätskonstante klein gehalten werden. Beispielsweise können Bauteile zu diesem Zweck in einer Keramik-Technologie ausgeführt werden. Dies ist wiederum von Vorteil bei Mobilfunktelefonen.

Im folgenden soll nunmehr das Verfahren erläutert werden, das zur Einstellung eines programmierbaren HF-Blocks gemäß der vorliegenden Erfindung ausgeführt wird. Zuerst werden die Werte des mechanisch einstellbaren Kondensators, Spule und/oder Resonators durch Ansteuerung eines Mikromotors gewählt. Die Bewegung des Mikromotors wird durch eine Software in der Steuereinheit 117 gesteuert. Somit erfolgt die Anpassung des Anpassungsnetzwerks spezifisch für das damit verbundene aktive Bauteil (Transistor, Diode etc.) unter Verwendung einer geeigneten Kombination an Kondensatoren, Spulen und Resonatoren. Für jeden Schaltungstyp wird eine geeignete Topologie für das Anpassungsnetzwerk gewählt. Schließlich kann mittels einer Berechnung oder eines Algorithmus das Signalantwortverhalten von jedem HF-Block in einem Mobiltelefon durch Veränderung der Werte der Anpassungsnetzwerk-Bauteile eingestellt und optimiert werden. Die Steuerdaten der Steuereinheit 117 können in dem Speicher 118 abgelegt und bei späterer neuer Einstellung gegebenenfalls wiederverwendet werden.

Es ist darauf hinzuweisen, daß das in Fig. 6 gezeigte Anpassungsnetzwerk nur ein Ausführungsbeispiel darstellt und ein Anpassungsnetzwerk gemäß der vorliegenden Erfindung allgemein beispielsweise nur als ein Kondensator, aber auch als eine aufwendige Kombination einer kaskadenförmigen Verschaltung von Kondensatoren, Spulen und Resonatoren ausgeführt werden kann.

Wie bereits erwähnt, wird der HF-Block insgesamt hinsichtlich seines Signalverhaltens eingestellt. Dabei können insbesondere die folgenden Parameter berücksichtigt werden:
a) Arbeitsfrequenz, bei der die Schaltung (HF-Block) betrieben werden soll,
b) Bandbreite
c) Ausgangsleistung und Verstärkung,
d) Rauschverhalten des HF-Blocks.

Bei einer Schaltung mit einem fest vorgegebenen Anpassungsnetzwerk sind die Schaltungsparameter vorbestimmt und können nicht mehr verändert werden. Somit ist die insgesamt erzielte Leistung ein Kompromiß der verschiedenen Parameter.

Im folgenden sollen noch kurz verschiedene Anwendungsfälle der vorliegenden Erfindung für verschiedene aktive Bauteile erläutert werden.

Für alle Arten an Verstärkern, Mischern und Oszillatoren kann die Arbeitsfrequenz durch Abstimmung des Anpassungsnetzwerks eingestellt werden. Somit kann der HF-Block einen breiten Frequenzbereich abdecken, in dem beispielsweise ein abstimmbarer Breitband-Leistungsverstärker, Breitband-Mischer etc. implementiert wird.

Bei allen Arten an Verstärkern und Mischern kann eine große Bandbreite auf eine geringere bzw. umgekehrt durch Abstimmung des Anpassungsnetzwerks eingestellt werden. Somit kann die Selektivität der Schaltung insgesamt verbessert werden.

Bei allen Verstärkern mit niedrigem Rauschen kann eine Auslegung auf ein optimales Rauschverhalten hin abhängig von der Stärke des Eingangssignals durch Abstimmung des Anpassungsnetzwerks beispielsweise durch Einstellung des entsprechenden Verstärkungsfaktors optimiert werden. Dies verbessert beispielsweise die Intermodulationseigenschaft der Schaltung.

Bei Leistungsverstärkern kann eine Abstimmung hinsichtlich der gewünschten Amplitude des Ausgangssignals oder des Wirkungsgrads durch Einstellen des Anpassungsnetzwerks erfolgen. Somit kann beispielsweise die Lebensdauer einer Batterie eines Mobiltelefons verlängert werden.

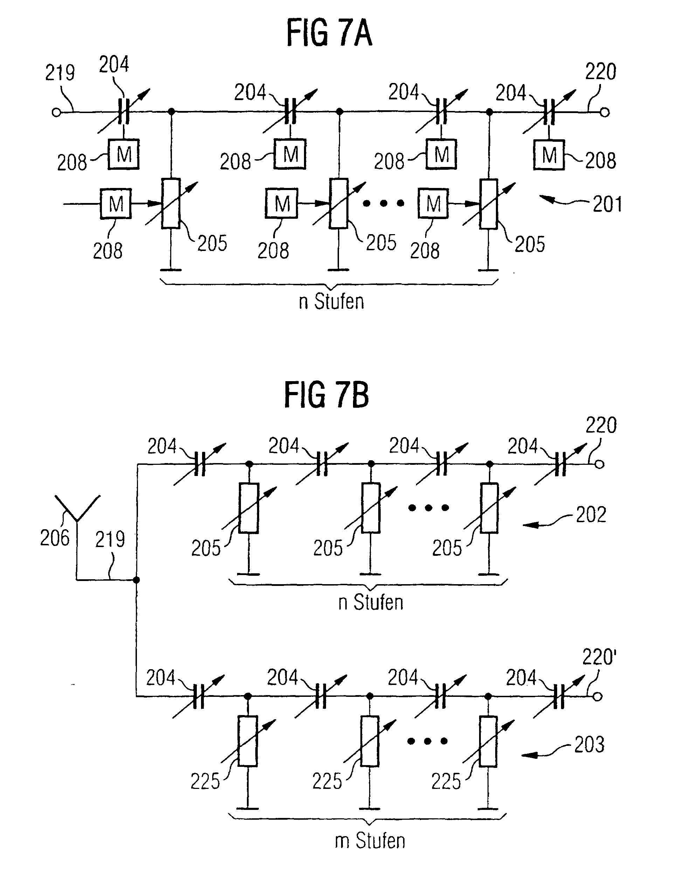

Bezug nehmend auf Fig. 7a wird zuerst eine programmierbare Filterschaltung gemäß der vorliegenden Erfindung erläutert.

Die in Fig. 7a dargestellte Filterschaltung weist einen Eingang 219 und einen Ausgang 220 auf. Zwischen dem Eingang 219 und dem Ausgang 220 sind einstellbare Kondensatoren 204 in Serie geschaltet. Die Kondensatoren 204 sind dabei jeweils von dem Typ, dessen Kapazitätswert mechanisch verstellt werden kann. Dazu ist jeweils ein elektrischer Mikromotor 208 einem Kondensator 204 mit verstellbarer Kapazität zugeordnet. Selbstverständlich kann auch ein elektrischer Mikromotor mit mehr als einem Kondensator 204 mechanisch verbunden sein, um entsprechend die Kapazitätswerte der mit ihm verbundenen Kondensatoren zu verstellen.

Zwischen den Verbindungspunkten zwischen den einzelnen Kondensatoren 204 und Erde ist jeweils eine Induktivität 205 oder Resonator geschaltet. Diese Induktivitäten 205 sind ebenfalls mechanisch einstellbar, und dazu ist ähnlich wie bei den Kondensatoren 204 im dargestellten Ausführungsbeispiel jeweils ein elektrischer Mikromotor 208 je einer verstellbaren Induktivität 205 zugeordnet. Die in Fig. 7a dargestellte Filterschaltung ist, wie ersichtlich, eine Filterschaltung mit n Stufen.

Die in Fig. 7a gezeigte Filtertopologie ist Grundlage des in Fig. 5b dargestellten Duplexers. Der in Fig. 5b dargestellte Duplexer weist nämlich zwei Filterschaltungen 202 bzw. 203 auf, die mittels einer gemeinsamen Leitung von ihrem Eingang 219 her mit einer Antenne 206 verbunden sind. Die Filterschaltung 202 weist dabei n Stufen auf und die Filterschaltung 203 m Stufen, wobei n = m sein kann. Beispielsweise zur Schaffung eines Frequenzmultiplexbetriebs (FDD) kann die Filterschaltung 202 hinsichtlich der sie bildenden passiven Bauteile 204, 205 so eingestellt sein, daß ihre Arbeitsfrequenz von der der Filterschaltung 203 unterscheidet.

Die in Fig. 7a und 7b gezeigten programmierbaren Filterschaltungen 201 bzw. 202, 203 basieren auf einer Bandpaß-Filtertechnologie. Indessen ist ersichtlich, daß sich die vorliegenden Erfindung genauso auf alle übrigen bekannten Filtertechnologien, wie beispielsweise Tiefpaß- oder Hochpaßfilter sowie Notchfilter (Bandsperre) anwenden läßt.

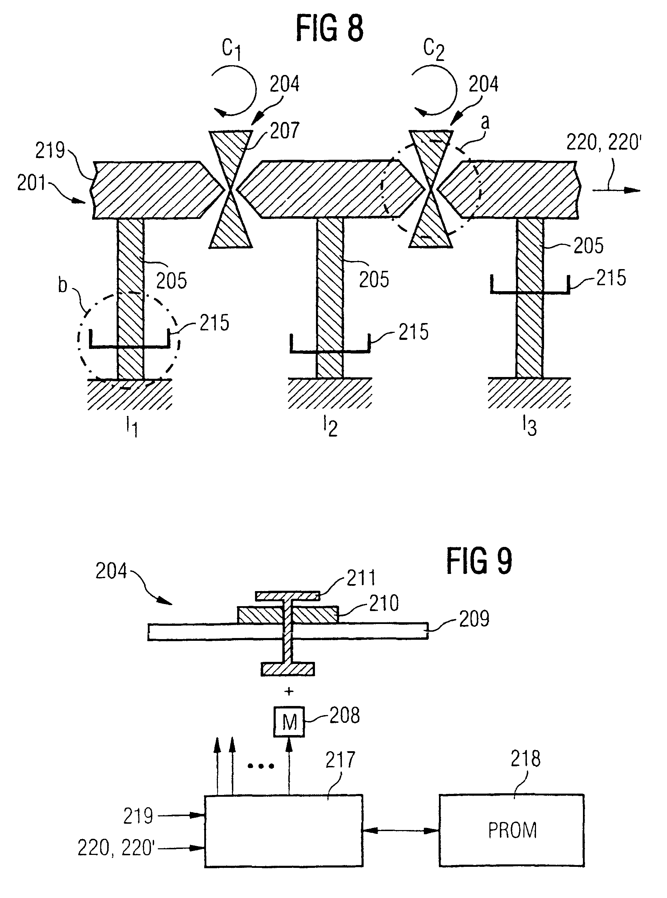

In dem in Fig. 8 gezeigten Ausschnitt sind zwei mechanisch einstellbare Kondensatoren 204 zu sehen, bei denen zur Einstellung ihrer Kapazität jeweils eine Metallscheibe 207 gedreht wird.

Weiterhin sind in Fig. 8 drei Induktivitäten/Resonatoren 5 gezeigt, deren effektive Länge durch Verschiebung eines Kurzschlußleiters 215 eingestellt werden kann, um die entsprechenden Kennwerte des Bauteils zu verändern.

In Fig. 9 ist ein Ausschnitt von Fig. 8 zu sehen, der in Fig. 8 mit a) bezeichnet ist. Der in Fig. 9 gezeigte mechanisch einstellbare Kondensator 204 besteht im wesentlichen aus einer Metallplatte 211, die sandwichartig über einem Dielektrikum 210 liegt, das wiederum über einer gedruckten Schaltungsplatine (PCB, Printed Circuit Board) 209 liegt. Mittels eines elektrischen Mikromotors 208 kann die Metallscheibe 211 des Kondensators 204 gedreht werden, um die Kapazität des Kondensators 204 mechanisch zu verändern.

Der elektrische Mikromotor 208 wird dabei von einer Steuereinheit 217 angesteuert. Wie durch Pfeile in Fig. 9 symbolisch dargestellt ist, kann die Steuereinheit 217 darüber hinaus mehrere oder sämtliche passiven Bauteile, die mechanisch verstellbar sind und die die Filterschaltung 201 bzw. 202, 203 bilden, durch Ansteuerung eines entsprechenden elektrischen Mikromotors 208 verstellen.

Die Steuereinheit 217 führt diese Einstellung der einzelnen Bauteile so aus, daß die Filterschaltung insgesamt zwischen ihrem Eingang 219 und ihrem Ausgang 220 bzw. 220' eine vorbestimmte Frequenzkennlinie aufweist. Dazu werden der Steuereinheit 217 als Informationen die Signale zugeführt, die an dem Eingang 219 bzw. an dem Ausgang 220, 220' der Filterschaltung anliegen, wie ebenfalls durch Pfeile symbolisch in Fig. 3 dargestellt ist. Mittels der zugeführten Signale vom Eingang 219 bzw. vom Ausgang 220, 220' kann die Steuereinheit 217 die Frequenzkennlinie der Filterschaltung ermitteln und bestimmen, ob diese tatsächliche Frequenzkennlinie mit einer Soll-Frequenzkennlinie übereinstimmt.

Als Alternative kann die Steuereinheit 217 selbst die Ansteuerwerte für die elektrischen Mikromotoren 208 berechnen, die zur Erzielung einer vorbestimmten Frequenzkennlinie benötigt werden. Die einzustellende Frequenzkennlinie kann in der Steuereinheit 217 selbst abgelegt sein oder aber auch online beispielsweise mittels einer Luftschnittstelle im Falle eines Mobilfunkgeräts zu der Steuereinheit 217 übertragen werden.

Wie in Fig. 9 ebenfalls dargestellt, ist mit der Steuereinheit 217 ein PROM-Speicher 218 vorgesehen. In dem PROM-Speicher 218 können Einstellwerte bzw. Ansteuerwerte für die elektrischen Mikromotoren 208 und gegebenenfalls vorbestimmte Frequenzkennlinien für die Filterschaltung insgesamt in Form einer Tabelle dauerhaft abgelegt werden. Somit kann die Steuereinheit 217 zur Erzielung einer vorbestimmten Frequenzkennlinie der Filterschaltung auf die in dem PROM 218 abgelegte Tabelle zurückgreifen.

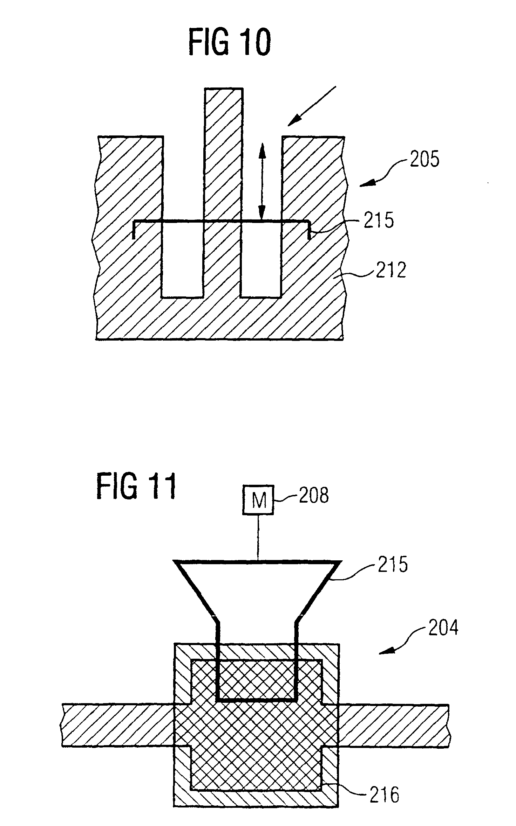

Fig. 10 zeigt einen Ausschnitt von Fig. 8, der in Fig. 8 mit b) bezeichnet ist. In dem in Fig. 10 dargestellten Ausführungsbeispiel ist das passive Bauteil ein Resonator 205. Durch mechanisches Verschieben eines Kurzschlußleiters 205, angesteuert durch einen elektrischen Mikromotor 208 hinsichtlich seiner Position bezüglich der Erdung 212 können durch die Steuereinheit 217 angesteuert die Kennwerte des Resonators 205 eingestellt werden.

Fig. 11 zeigt ein weiteres Ausführungsbeispiel für einen mechanisch verstellbaren Kondensator 204. In diesem Fall wird eine Metallplatte 215 bezüglich dem Dielektrikum 216 in einer Ebene senkrecht zu der Ebene des Dielektrikums 216 verschoben, wobei diese Verschiebung durch einen elektrischen Mikromotor 208 erfolgt, der wiederum von der Steuereinheit 217 angesteuert wird.

Selbstverständlich können zur programmierten Verstellung der Kapazitätswerte von Kondensatoren auch handelsübliche abstimmbare Kondensatorbauteile verwendet werden, wobei die Verstellung durch mechanische Verwendung mit einem elektrischen Mikromotor erfolgen kann.

Wie aus der obigen Beschreibung von Ausführungsbeispielen ersichtlich ist, werden im Zuge der vorliegenden Erfindung rein passive Schaltbauteile verwendet, so daß einerseits der Energieverbrauch niedrig gehalten werden kann und andererseits Nichtlinearitäts-Probleme, wie sie beispielsweise bei der Yig- oder Varaktor-Technologie auftreten, vermieden werden. Bei der erfindungsgemäßen programmierbaren Filterschaltung wird nur elektrische Energie verbraucht, wenn ein Mikromotor eine Einstellung eines passiven Bauteils ausführt. Es wird daran erinnert, daß gemäß dem Stand der Technik bei einer Pin-Diodentechnologie ständig elektrische Energie verbraucht wird. Wie bereits ausgeführt, kann ein PCB-Filter-Duplexer gemäß der vorliegenden Erfindung in einer Keramik-Technologie ausgeführt werden, die eine hohe Dielektrizitätskonstante aufweist, was zu einer Verringerung der Komponenten-Abmessungen führt.

Es wird daran erinnert, daß gemäß dem Stand der Technik ein oder mehrere Mikromotoren mit mechanischer Übertragung in einer sehr kleinen Bauform ausgeführt werden, die den Abmessungen eines Mobilteils integrierbar sind.

Es wird daran erinnert, daß jegliche bekannte Schaltungs-Topologie, die eine Filterfunktion oder Duplexer-Funktion aufweist, als Grundlage für die vorliegende Erfindung dienen kann. Auf dieser Grundlage können dann die Kennwerte des einstellbaren (programmierbaren) Kondensators, der Induktivität oder eines Resonators in der Schaltungs-Topologie durch einen Mikromotor verändert werden, der. wiederum elektrisch durch eine Steuereinheit ansteuerbar ist.

Mittels einer Berechnung oder eines geeigneten Algorithmus können dann die Kennwerte, wie beispielsweise die Kapazität oder der Resonanzwert, so verändert werden, daß die gewünschte Filter- oder Duplexer-Kennlinie mit einer gewünschten Mittenfrequenz und Bandbreite erhalten wird.

### Bezugszeichenliste

- 1: Mobilfunk-Endgerät
- 3: Basisband-Block
- 5: Empfangsstufe
- 7: Sendestufe
- 9: Steuerstufe
- 11: Duplexer
- 13: Antenne
- 15a, 15b: Sendesignal-Filterstufe
- 17a, 17b: Empfangssignal-Filterstufe
- C₁, C₂, C₃, C₄, C₅: Kondensator
- 11, 12: Induktivität
- MS_{i, j, k, l, m}: Mikroschalter
- MM₁, MM₂: Mikromotor
- 90: Abstimmsteuerung
- 90a: Abstimmablaufsteuerung
- 90b: Ein-/Ausschalter
- 90c: Inverter
- 90d: Schalterkonfigurations-Berechnungsstufe
- 90f: Algorithmenspeicher
- 90g: Ansteuersignalgenerator
- 90h: Programmende-Detektor
- C: Steuerung
- M: Konfigurationenspeicher
- P: Zeigerstufe
- R/T: HF-Teil
- S: Steuersignalleitung
- Sw: Ein-/Ausschalter
- 101: Anpassungsnetzwerk
- 102: Anpassungsnetzwerk
- 103: Anpassungsnetzwerk
- 104: aktives Bauteil (Verstärker)
- 105: aktives Bauteil (Mischer)
- 106: aktives Bauteil (Oszillator)
- 107: Kondensator
- 108: Kondensator
- 109: Kondensator
- 110: Induktivität (Spule)
- 111: Induktivität (Spule)
- 112: Mikromotor
- 113: Mikromotor
- 114: Mikromotor
- 115: Mikromotor
- 116: Mikromotor
- 117: Steuereinheit
- 118: Speicher
- 119: Eingang der Steuereinheit
- 120: Eingang der Steuereinheit
- 121: Eingangsanschluß des Anpassungsnetzwerks
- 122: Ausgangsanschluß des Abstimmnetzwerks
- 123: Antenne
- 124: Luftschnittstelle
- 125: Eingang der Steuereinheit
- 126: Eingang der Steuereinheit
- 201: programmierbare Filterschaltung
- 202, 203: programmierbare Filterschaltungen des Duplexers
- 204: einstellbarer Kondensator
- 205: einstellbare Induktivität/Resonator
- 206: Antenne
- 207: Metallscheibe
- 208: elektrischer Mikromotor
- 209: gedruckte Schaltungsplatine
- 210: Dielektrikum
- 211: Metallscheibe
- 212: Erdungspotential
- 215: Metallplatte
- 216: Dielektrikum

## Patentansprüche

1. Mobilfunk-Endgerät, aufweisend
- eine Sendestufe (7, 15a, 15b),
- eine Empfangsstufe (5, 17a, 17b),
- eine Antennenumschalt- und -anpaßstufe (11),
die jeweils eine Anordnung passiver Bauelemente aufweisen, welcher eine Mehrzahl von elektrostatisch-mechanischen Mikroschaltern (MSᵢ-MSₘ) bzw. Mikrorelais (MRᵢ, MRⱼ) zugeordnet ist und die durch Ansteuerung einer vorbestimmten Konfiguration der Mikroschalter bzw. Mikrorelais in mindestens je einem Funktionsparameter, insbesondere der Frequenzcharakteristik, einstellbar ist,
**dadurch gekennzeichnet,**
**daß** eine über eine Luftschnittstelle (124) programmierbare Steuereinheit (9; 90; C) zur Ansteuerung der Mikroschalter- bzw. Mikrorelaiskonfiguration zur Einstellung vorbestimmter Werte des Funktions-parameters bzw. der Funktionsparameter vorhanden ist.

2. Mobilfunk-Endgerät nach Anspruch 1,
**dadurch gekennzeichnet,**
**dass** mindestens eine der Sendestufe (7, 15a, 15b), Empfangsstufe (5, 17a, 17b), und Antennenumschalt- und -anpaßstufe (11) eine Mehrzahl von Mikromotoren zur mechanischen Verstellung passiver Bauelemente aufweist, wobei die Mikromotoren (MM₁, MM₂) in Steuerverbindung mit der Steuereinheit stehen.

3. Mobilfunk-Endgerät nach Anspruch 2,
**dadurch gekennzeichnet,**
**daß** die Steuereinheit (90; C) einen Ein-/Ausschalter (90b; Sw) für die Sende- und die Empfangsstufe aufweist und derart ausgebildet ist, daß jeweils vor Ausgabe eines Ansteuersignals an die Mikroschalter- bzw. Mikrorelaiskonfiguration und wahlweise einen Mikromotor ein Ausschaltsignal an den Ein-/Ausschalter zur Deaktivierung der Sende- und/oder Empfangsstufe (5; R/T) ausgegeben wird.

4. Mobilfunk-Endgerät nach Anspruch 3,
**dadurch gekennzeichnet,**
**daß** die Steuereinheit (90) eine mit dem Ein-/Ausschalter (90b) verbundene Programmende-Erfassungseinheit (90h) aufweist, die nach Beendigung eines Programmablaufes zur Einstellung eines oder mehrerer Funktionsparameter ein Einschaltsignal an den Ein-/Ausschalter zur Aktivierung der Sende- und/oder Empfangsstufe (5) ausgibt.

5. Mobilfunk-Endgerät nach einem der vorangehenden Ansprüche,
**dadurch gekennzeichnet,**
**daß** mindestens ein Teil der Mikroschalter bzw. Mikrorelais mit den jeweils zugehörigen passiven Bauelementen auf ein und demselben Substrat, insbesondere einem Substrat mit hoher Dielektrizitätskonstante, integriert ist.

6. Mobilfunk-Endgerät nach Anspruch 2,
**dadurch gekennzeichnet,**
**daß** mindestens ein Teil der Mikromotoren mit den jeweils zugehörigen passiven Bauelementen auf ein und demselben Substrat, insbesondere einem Substrat mit hoher Dielektrizitätskonstante, integriert ist.

7. Mobilfunk-Endgerät nach einem der vorangehenden Ansprüche,
**dadurch gekennzeichnet,**
**daß** die Steuereinheit (90)
- einen Topologiespeicher (90e) zur Speicherung der Topologie der den oder die Funktionsparameter bestimmenden Anordnung aus passiven Bauelementen und Mikroschaltern bzw. Mikrorelais,
- einen Algorithmenspeicher (90f) zur Speicherung eines Berechnungs-Algorithmus für vorbestimmte Werte jedes Funktionsparameters aufgrund von Topologieelementen und
- eine Berechnungsstufe (90d) zur Ermittlung der zur Realisierung des vorbestimmten Wertes oder der vorbestimmten Werte anzusteuernden Mikroschalter bzw. Mikrorelais der Konfiguration aufgrund des gespeicherten Berechnungsalgorithmus
aufweist.

8. Mobilfunk-Endgerät nach Anspruch 7,
**dadurch gekennzeichnet,**
**daß** der Topologiespeicher (90e) zur Speicherung der Position sowie eines den möglichen Ansteuerstufen jedes Mikromotors entsprechenden Topologie-Äquivalents und die Berechnungsstufe (90d) zur Berechnung des zur Realisierung eines vorbestimmten Wertes des Funktionsparameters auszugebenden Ansteuersignals für jeden Mikromotor ausgebildet ist.

9. Mobilfunk-Endgerät nach einem der Ansprüche 1 bis 7,
**dadurch gekennzeichnet,**
**daß** die Steuereinheit (C)
- einen als Lookup-Table ausgebildeten Konfigurationenspeicher (M) zur Speicherung einer Mehrzahl von Schaltstellungskonfigurationen der Mikroschalter bzw. Mikrorelais jeweils in Zuordnung zu einem Wert eines Funktionsparameters oder einem Werte-Vektor mehrerer Funktionsparameter und
- eine Zeigerstufe (P) zur Adressierung des Konfigurationenspeichers in Abhängigkeit von einem programmierbaren Wert oder Werte-Vektor aufweist.

10. Mobilfunk-Endgerät nach Anspruch 9,
**dadurch gekennzeichnet,**
**daß** der Konfigurationenspeicher (M) zur Speicherung von kombinierten Schalterstellungs- und Motoransteuerungs-Konfigurationen einer Bauelementanordnung ausgebildet ist, in der neben Mikroschaltern bzw. Mikrorelais Mikromotoren zur Verstellung passiver Bauelemente vorgesehen sind.

11. Programmierbarer HF-Block für Mobilfunk-Anwendungen, aufweisend
- ein aktives Bauteil (104, 105, 106),
- wenigstens ein mechanisch abstimmbares Anpassungsnetzwerk (101, 102, 103), das individuell einstellbare passive Bauteile (107, 108, 109, 110, 111) aufweist und mit dem aktiven Bauteil (104, 105, 106) verbunden ist,
**dadurch gekennzeichnet,**
**daß** eine über eine Luftschnittstelle (124) programmierbare Steuereinheit (117) vorhanden ist, die das mechanisch abstimmbare Anpassungsnetzwerk (101, 102, 103) so einstellt, daß der HF-Block insgesamt vorbestimmte Eigenschaften hinsichtlich seines Signalantwortverhaltens aufweist.

12. Programmierbarer HF-Block nach Anspruch 11,
**dadurch gekennzeichnet,**
**dass** jeweils einem einstellbaren passiven Bauteil (107, 108, 109, 110, 111) ein elektrischer Mikromotor (112, 113, 114, 115, 116) zugeordnet ist und die programmierbare Steuereinheit (117) die Mikromotoren (112, 113, 114, 115, 116) zur Einstellung des mechanisch abstimmbaren Anpassungsnetzwerks (101, 102, 103) ansteuert.

13. Programmierbarer HF-Block nach Anspruch 12,
**dadurch gekennzeichnet,**
**daß** die Mikromotoren (112, 113, 114, 115, 116) nur während der Zeitdauer der Einstellung des mechanisch abstimmbaren Anpassungsnetzwerks (101, 102, 103) aktiviert sind und außerhalb dieser Zeitdauer die elektrische Versorgung der Mikromotoren (112, 113, 114, 115, 116) abgeschaltet wird.

14. Programmierbarer HF-Block nach einem der vorhergehenden Ansprüche,
**dadurch gekennzeichnet,**
**daß** ein Speicher (118) mit der programmierbaren Steuereinheit (117) verbunden ist, in dem Einstellwerte für das mechanisch abstimmbare Anpassungsnetzwerk (101, 102, 103) und/oder vorbestimmte Eigenschaften des HF-Blocks hinsichtlich seines Signalanwortverhaltens dauerhaft abgelegt sind.

15. Programmierbarer HF-Block nach Anspruch 14,
**dadurch gekennzeichnet,**
**daß** in dem Speicher (118) eine Tabelle angelegt ist, die die zur Erzielung eines bestimmten Signalanwortverhaltens des HF-Blocks erforderlichen Einstellwerte für das mechanisch abstimmbare Anpassungsnetzwerk (101, 102, 103) wiedergibt.

16. Programmierbarer HF-Block nach einem der vorhergehenden Ansprüche,
**dadurch gekennzeichnet,**
**daß** die programmierbare Steuereinheit (117) den HF-Block hinsichtlich seiner Eigenschaften betreffend der Arbeitsfrequenz, der Bandbreite, der Verstärkungsleistung und/oder des Rauschverhaltens einstellt.

17. Programmierbarer HF-Block nach einem der vorhergehenden Ansprüche,
**dadurch gekennzeichnet,**
**daß** die programmierbare Steuereinheit (117) die zur Erzielung eines bestimmten Signalanwortverhaltens des HF-Blocks erforderlichen Einstellwerte für das mechanisch abstimmbare Anpassungsnetzwerk (101, 102, 103) selbst berechnet.

## Claims

1. Mobile phone terminal having
- a transmitter stage (7, 15a, 15b),
- a receiver stage (5, 17a, 17b),
- an antenna switch-over and adapter stage (11),
which each have an arrangement of passive structural elements, which arrangement is assigned a multiplicity of electrostatic-mechanical microswitches (MSᵢ-MSₘ) or microrelays (MRᵢ, MRⱼ) and which can be set by actuating a predetermined configuration of the microswitches or microrelays in, in each case, at least one functional parameter, in particular the frequency characteristic,
**characterized in that** a control unit (9; 90; C) which can be programmed over an air interface (124) for actuating the microswitch or microrelay configuration for setting predetermined values of the functional parameter or the functional parameters, is present.

2. Mobile phone terminal according to Claim 1, **characterized in that** at least one of the transmitter stage (7, 15a, 15b), receiver stage (5, 17a, 17b) and antenna switch-over and adapter stage (11) has a multiplicity of micromotors for mechanically adjusting passive structural elements, the micromotors (MM₁, MM₂) having a control connection to the control unit.

3. Mobile phone terminal according to Claim 2, **characterized in that** the control unit (90; C) has an on/off switch (90b; Sw) for the transmitter stage and the receiver stage and is embodied in such a way that, in each case before an actuation signal is transmitted to the microswitch configuration or microrelay configuration, and optionally to a micromotor, a switch-off signal is transmitted to the on/off switch in order to deactivate the transmitter stage and/or receiver stage (5; R/T).

4. Mobile phone terminal according to Claim 3, **characterized in that** the control unit (90) has a program-end sensing unit (90h) which is connected to the on/off switch (90b) and transmits, after the termination of a program run for setting one or more functional parameters, a switch-on signal to the on/off switch in order to activate the transmitter and/or receiver stage (5).

5. Mobile phone terminal according to one of the preceding claims, **characterized in that** at least some of the microswitches or microrelays are integrated with the respectively associated passive structural elements on one and the same substrate, in particular a substrate with a high dielectric constant.

6. Mobile phone terminal according to Claim 2, **characterized in that** at least some of the micromotors are integrated with the respectively associated passive structural elements on one and the same substrate, in particular a substrate with a high dielectric constant.

7. Mobile phone terminal according to one of the preceding claims, **characterized in that** the control unit (90) has
- a topology memory (90e) for storing the topology of the arrangement which determines the functional parameter or parameters and is composed of passive structural elements and microswitches or microrelays,
- an algorithm memory (90f) for storing a calculation algorithm for predetermined values of each functional parameter on the basis of topology elements, and
- a calculation stage (90d) for determining, on the basis of the stored calculation algorithm, the configuration microswitches or microrelays which are to be actuated in order to implement the predetermined value or the predetermined values.

8. Mobile phone terminal according to Claim 7, **characterized in that** the topology memory (90e) is designed to store the position and a topology equivalent corresponding to the possible actuator stages of each micromotor, and the calculation stage (90d) is designed to calculate the actuation signal for each micromotor, which signal is to be output in order to implement a predetermined value of the functional parameter.

9. Mobile phone terminal according to one of Claims 1 to 7, **characterized in that** the control unit (C) has
- a configuration memory (M) which is embodied as a lookup table and has the purpose of storing a multiplicity of switched setting configurations of the microswitches or microrelays, in each case in an assignment to a value of a functional parameter or a values vector of a plurality of functional parameters, and
- a pointer stage (P) for addressing the configuration memory as a function of a programmable value or values vector.

10. Mobile phone terminal according to Claim 9, **characterized in that** the configuration memory (M) is designed to store combined switch setting and motor actuation configurations of a structural element arrangement in which not only microswitches or microrelays but also micromotors are provided for adjusting passive structural elements.

11. Programmable RF block for mobile phone applications, having
- an active component (104, 105, 106),
- at least one mechanically tunable adapter network (101, 102, 103) which has individually adjustable passive components (107, 108, 109, 110, 111) and is connected to the active component (104, 105, 106),
**characterized in that** a control unit (117) which can be programmed over an air interface (124) and sets the mechanically tunable adapter network (101, 102, 103) in such a way that all the properties of the RF block relating to its signal response characteristic are predetermined, is present.

12. Programmable RF block according to Claim 11, **characterized in that** each adjustable passive component (107, 108, 109, 110, 111) is assigned an electric micromotor (112, 113, 114, 115, 116), and the programmable control unit (117) actuates the micromotors (112, 113, 114, 115, 116) in order to set the mechanically tunable adapter network (101, 102, 103).

13. Programmable RF block according to Claim 12, **characterized in that** the micromotors (112, 113, 114, 115, 116) are activated only during the period of adjustment of the mechanically tunable adapter network (101, 102, 103), and outside this period the supply of electricity to the micromotors (112, 113, 114, 115, 116) is switched off.

14. Programmable RF block according to one of the preceding claims, **characterized in that** a memory (118) is connected to the programmable control unit (117) in which setting values for the mechanically tunable adapter network (101, 102, 103) and/or predetermined properties of the RF block relating to its signal response characteristic are permanently stored.

15. Programmable RF block according to Claim 14, **characterized in that** a table which represents the setting values, necessary to achieve a specific signal response characteristic of the RF block, for the mechanically tunable adapter network (101, 102, 103) is created in the memory (118).

16. Programmable RF block according to one of the preceding claims, **characterized in that** the programmable control unit (117) sets the RF block with respect to its properties relating to the operating frequency, bandwidth, amplification power and/or noise characteristics.

17. Programmable RF block according to one of the preceding claims, **characterized in that** the programmable control unit (117) itself calculates the setting values, necessary to achieve a specific signal response characteristic of the RF block, for the mechanically tunable adapter network (101, 102, 103).

## Revendications

1. Terminal de radiocommunication mobile, comportant :
- un étage d'émission (7, 15a, 15b),
- un étage de réception (5, 17a, 17b),
- un étage de commutation et d'adaptation d'antenne (11),
qui comportent chacun un dispositif de composants passifs auquel est associée une multiplicité de microcommutateurs (MSᵢ à MSₘ) ou microrelais (MRᵢ, MRⱼ) à mécanique électrostatique et qui est réglable par commande d'une configuration prédéterminée des microcommutateurs ou microrelais pour au moins un paramètre fonctionnel, notamment la caractéristique fréquentielle,
**caractérisé par le fait qu'**il y a une unité de commande (9 ; 90 ; C) programmable par l'intermédiaire d'une interface radio (124) pour la commande de la configuration de microcommutateurs ou microrelais en vue du réglage de valeurs prédéterminées du ou des paramètres fonctionnels.

2. Terminal de radiocommunication mobile selon la revendication 1,
**caractérisé par le fait qu'**au moins l'un des étages parmi l'étage d'émission (7, 15a, 15b), l'étage de réception (5, 17a, 17b) et l'étage de commutation et d'adaptation d'antenne (11) comporte une multiplicité de micromoteurs pour le réglage mécanique de composants passifs, les micromoteurs (MM₁, MM₂) étant en liaison de commande avec l'unité de commande.

3. Terminal de radiocommunication mobile selon la revendication 2,
**caractérisé par le fait que** l'unité de commande (90 ; C) comporte un connecteur / déconnecteur (90b ; Sw) pour l'étage d'émission et l'étage de réception et est conçue de telle sorte que, avant chaque envoi d'un signal de commande à la configuration de microcommutateurs ou microrelais et éventuellement à un micromoteur, un signal de coupure est envoyé au connecteur / déconnecteur pour la désactivation de l'étage d'émission et/ou l'étage de réception (5 ; R / T).

4. Terminal de radiocommunication mobile selon la revendication 3,
**caractérisé par le fait que** l'unité de commande (90) comporte une unité de détection de fin de programme (90h) qui est reliée à un connecteur / déconnecteur (90b) et qui, après la fin d'une exécution de programme pour le réglage d'un ou plusieurs paramètres fonctionnels, fournit un signal de branchement au connecteur / déconnecteur pour l'activation de l'étage d'émission et/ou l'étage de réception (5).

5. Terminal de radiocommunication mobile selon l'une des revendications précédentes,
**caractérisé par le fait qu'**au moins une partie des microcommutateurs ou microrelais est intégrée avec les composants passifs respectivement associés sur un seul et même substrat, notamment un substrat ayant une constante diélectrique élevée.

6. Terminal de radiocommunication mobile selon la revendication 2,
**caractérisé par le fait qu'**au moins une partie des micromoteurs est intégrée avec les composants passifs respectivement associés sur un seul et même substrat, notamment un substrat ayant une constante diélectrique élevée.

7. Terminal de radiocommunication mobile selon l'une des revendications précédentes,
**caractérisé par le fait que** l'unité de commande (90) comporte
- une mémoire de topologies (90e) pour la mémorisation de la topologie du dispositif déterminant le ou les paramètres fonctionnels et constitué de composants passifs et de microcommutateurs ou microrelais,
- une mémoire d'algorithmes (90f) pour la mémorisation d'un algorithme de calcul pour des valeurs prédéterminées de chaque paramètre fonctionnel sur la base des éléments de topologie, et
- un étage de calcul (90d) pour déterminer en fonction de l'algorithme de calcul mémorisé les microcommutateurs ou microrelais de la configuration qui sont à commander pour la réalisation de la ou des valeurs prédéterminées.

8. Terminal de radiocommunication mobile selon la revendication 7,
**caractérisé par le fait que** la mémoire de topologie (90e) est conçue pour la mémorisation de la position ainsi que d'un équivalent topologique correspondant aux niveaux de commande possibles de chaque micromoteur et que l'étage de calcul (90d) est conçu pour le calcul du signal de commande à fournir pour chaque micromoteur en vue de la réalisation d'une valeur prédéterminée du paramètre fonctionnel.

9. Terminal de radiocommunication mobile selon l'une des revendications 1 à 7,
**caractérisé par le fait que** l'unité de commande (C) comporte
- une mémoire de configurations (M) conçue comme une Lookup-Table pour la mémorisation d'une multiplicité de configurations de position de commutation des microcommutateurs ou microrelais à chaque fois en association avec une valeur d'un paramètre fonctionnel ou avec un vecteur de valeurs de plusieurs paramètres fonctionnels, et
- un étage de pointeurs (P) pour l'adressage de la mémoire de configurations en fonction d'une valeur programmable ou d'un vecteur de valeurs programmables.

10. Terminal de radiocommunication mobile selon la revendication 9,
**caractérisé par le fait que** la mémoire de configurations (M) est conçue pour la mémorisation de configurations combinées de position de commutateurs et de commande de moteurs pour un dispositif à composants dans lequel sont prévus, outre des microcommutateurs ou microrelais, des micromoteurs pour le réglage de composants passifs.

11. Bloc HF programmable pour applications de radiocommunication mobile, comportant
- un composant actif (104, 105, 106),
- au moins un réseau d'adaptation à réglage mécanique (101, 102, 103) qui comporte des composants passifs individuellement réglables (107, 108, 109, 110, 111) et qui est relié au composant actif (104, 105, 106),
**caractérisé par le fait qu'**il y a une unité de commande (117) qui est programmable par l'intermédiaire d'une interface radio (124) et qui règle le réseau d'adaptation à réglage mécanique (101, 102, 103) de telle sorte que le bloc HF global a des propriétés prédéterminées quant à son comportement de réponse de signal.

12. Bloc HF programmable selon la revendication 11,
**caractérisé par le fait qu'**il est associé à chaque composant passif réglable (107, 108, 109, 110, 111) un micromoteur électrique (112, 113, 114, 115, 116) et que l'unité de commande programmable (117) commande les micromoteurs (112, 113, 114, 115, 116) pour le réglage du réseau d'adaptation à réglage mécanique (101, 102, 103).

13. Bloc HF programmable selon la revendication 12,
**caractérisé par le fait que** les micromoteurs (112, 113, 114, 115, 116) ne sont activés que pendant la durée du réglage du réseau d'adaptation à réglage mécanique (101, 102, 103) et que, en dehors de cet intervalle de temps, l'alimentation électrique des micromoteurs (112, 113, 114, 115, 116) est coupée.

14. Bloc HF programmable selon l'une des revendications précédentes,
**caractérisé par le fait qu'**il est relié à l'unité de commande programmable (117) une mémoire (118) dans laquelle sont enregistrées durablement des valeurs de réglage pour le réseau d'adaptation à réglage mécanique (101, 102, 103) et/ou pour des propriétés prédéterminées du bloc HF quant à son comportement de réponse de signal.

15. Bloc HF programmable selon la revendication 14,
**caractérisé par le fait qu'**il est enregistré dans la mémoire (118) un tableau qui reproduit les valeurs de réglage, nécessaires à l'obtention d'un certain comportement de réponse de signal du bloc HF, pour le réseau d'adaptation à réglage mécanique (101, 102, 103).

16. Bloc HF programmable selon l'une des revendications précédentes,
**caractérisé par le fait que** l'unité de commande programmable (117) règle le bloc HF quant à ses propriétés concernant la fréquence de travail, la largeur de bande, la puissance d'amplification et/ou le comportement au bruit.

17. Bloc HF programmable selon l'une des revendications précédentes,
**caractérisé par le fait que** l'unité de commande programmable (117) calcule elle-même les valeurs de réglage, nécessaires à l'obtention d'un certain comportement de réponse de signal du bloc HF, pour le réseau d'adaptation à réglage mécanique (101, 102, 103).
